# EUROPEAN PATENT SPECIFICATION

(11) **EP 2 535 949 B1**
(45) Date of publication and mention of the grant of the patent: **22.04.2020**
(21) Application number: 11830819.6
(22) Date of filing: 27.04.2011
(51) Int. Cl.: H01L 31/042, H02S 40/30

(54) **SOLAR PHOTOVOLTAIC DEVICE AND A CONVEYING DEVICE COMPRISING THE SAME**
SOLAR-PHOTOVOLTAIK-VORRICHTUNG UND FÖRDERVORRICHTUNG DAMIT
DISPOSITIF PHOTOVOLTAÏQUE SOLAIRE ET SON DISPOSITIF DE TRANSPORT

(30) Priority: 05.10.2010 KR 20100097058
(43) Date of publication of application: 19.12.2012
(73) Proprietor: LG Innotek Co., Ltd., Seoul, 04637 (KR)
(72) Inventor: BAE, Do Won, Seoul 100-714 (KR)
(74) Representative: Novagraaf Technologies
(86) International application number: PCT/KR2011/003114
(87) International publication number: WO 2012/046933

(56) References cited:
- JP-A- S62 248 267
- JP-A- 2010 507 199
- KR-A- 20080 053 469
- KR-A- 20080 053 469
- US-A- 5 470 396
- US-A- 5 542 988
- US-A- 5 542 988
- US-A1- 2010 139 743

## Description

### Technical Field

The embodiment relates to a solar cell apparatus and a transportation including the same.

### Background Art

A solar cell module for converting light energy into electric energy through the photoelectric transformation effect has been extensively used to obtain clean energy contributing to environmental conservation of the earth.

As the photoelectric transformation efficiency of a solar cell has been improved, a solar cell system including the solar cell module is used for the residential purpose. An example of such solar cell module is described in document KR 2008 0053469 A. US 5,542,988 discloses a photocell including means to protect it against accumulation of electrostatic charge, and a solar panel comprising such a photocell.

### Disclosure

### Technical Problem

The embodiment provides a solar cell apparatus which can be prevented from being damaged due to external electrical shock and a transfer apparatus including the same.

### Technical Solution

According to the embodiment, there is provided a solar cell apparatus including a solar cell panel, and an electrical shock protective part on the solar cell panel according to claim 1.

In addition, according to the embodiment, there is provided a transportation including the solar cell apparatus.

In particular, according to the embodiment, the solar cell apparatus further includes a protective substrate on the solar cell panel, and a buffer layer between the solar cell panel and the protective substrate. The electrical shock protective part is interposed between the protective substrate and the buffer layer.

### [Advantageous Effects]

As described above, according to the solar cell apparatus of the embodiment, the solar cell panel can be protected by using an electrical shock protective part.

In particular, the electrical shock protective part absorbs static electricity or a lightening stroke to prevent the solar cell panel from being damaged.

Therefore, the solar cell apparatus according to the embodiment can represent improved durability and improved reliability.

In particular, the solar cell apparatus according to the embodiment is applicable to a transportation such as a vehicle or an airplane. In this case, electrical shocks such as static electricity or the lightening stroke may be more applied to the transportation.

In this case, since the electrical shock protective part effectively protects the solar cell panel, the transportation according to the embodiment can represent improved durability and improved reliability.

### Description of Drawings

FIG. 1 is a plan view showing a solar cell module according to the embodiment;
FIG. 2 is a view showing an electrical shock protective part;
FIG. 3 is a sectional view showing the solar cell module according to the embodiment;
FIG. 4 is a sectional view showing the connection state of the electrical shock protective part and a frame;
FIG. 5 is a view showing a vehicle to which the solar cell module according to the embodiment is applied;
FIG. 6 is a view showing an airplane to which the solar cell module according to the embodiment is applied;
FIGS. 7 and 8 are sectional views showing a solar cell module according to another embodiment;
FIGS. 9 and 10 are sectional views showing a solar cell module according to still another embodiment; and
FIG. 11 is a view showing an electrical shock protective part according to still another embodiment.

### Best Mode

### Mode for Invention

In the description of the embodiments, it will be understood that, when a panel, a bar, a frame, a substrate, a groove, or a film is referred to as being "on" or "under" another panel, another bar, another substrate, another groove, or another film, it can be "directly" or "indirectly" on the other panel, the other bar, the other substrate, the other groove, or the other film, or one or more intervening layers may also be present. Such a position of each component has been described with reference to the drawings. The thickness and size of each component shown in the drawings may be exaggerated, omitted or schematically drawn for the purpose of convenience or clarity. In addition, the size of elements does not utterly reflect an actual size.

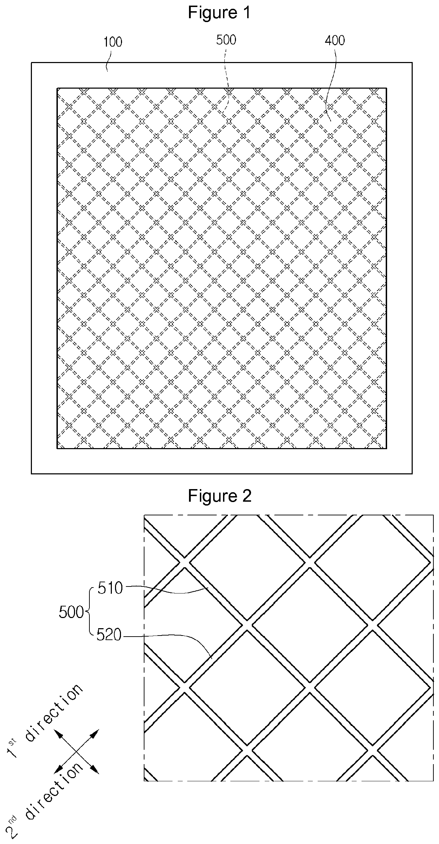

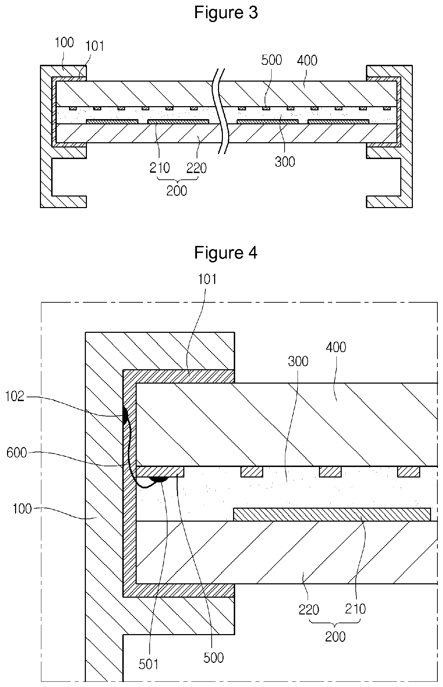

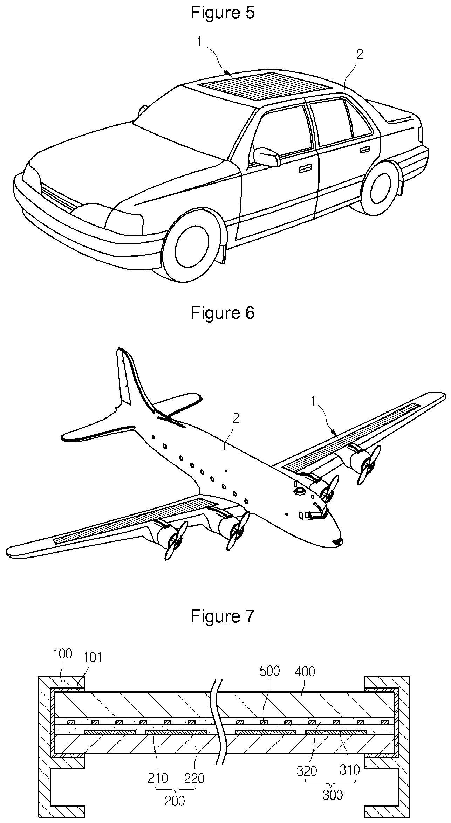

FIG. 1 is a plan view showing a solar cell module according to the embodiment, FIG. 2 is a view showing an electrical shock protective part, FIG. 3 is a sectional view showing the solar cell module according to the embodiment, and FIG. 4 is a sectional view showing the connection state of the electrical shock protective part and a frame. FIG. 5 is a view showing a vehicle to which the solar cell module according to the embodiment is applied, and FIG. 6 is a view showing an airplane to which the solar cell module according to the embodiment is applied.

Referring to FIGS. 1 to 4, the solar cell module according to the embodiment includes a frame 100, a solar cell panel 200, a protective substrate 400, a buffer sheet 300, and an electrical shock protective part 500.

The frame 100 is provided outside the solar cell panel 200. The frame 100 receives the solar cell panel 200, the protective substrate 400, the buffer sheet 300, and the electrical shock protective part 500. In more detail, the frame 100 surrounds the lateral sides of the solar cell panel 200.

The frame 100 may include a conductor. For example, the frame 100 may include a metallic frame 100. The material constituting the frame 100 may include aluminum, stainless steel, or iron.

The frame 100 may include four sub-frames. The sub-frames may be provided at the corners of the solar cell panel 200. The sub-frames may be coupled with each other.

The solar cell panel 200 is provided inside the frame 100. The solar cell panel 200 has a plate shape, and includes a plurality of solar cells 210.

The solar cells 210 may include a CIGS-based solar cell, a silicon-based solar cell, a dye-sensitized solar cell, a group II-VI compound semiconductor solar cell, or a group III-V compound semiconductor solar cell.

In addition, the solar cells 210 may be arranged on a transparent substrate 220 such as a glass substrate.

The solar cells 210 may be arranged in the shape of a stripe. In addition, the solar cells 210 may be arranged in various shapes such as a matrix shape. The solar cells 210 may be connected to each other in series and/or in parallel.

The protective substrate 400 is provided on the solar cell panel 200. In more detail, the protective substrate 400 is provided in opposition to the solar cell panel 200.

The protective substrate 400 is transparent and represents high strength. The protective substrate 400 may include tempered glass.

The buffer sheet 300 is interposed between the protective substrate 400 and the solar cell panel 200. The buffer sheet 300 protects the solar cell panel 200 from external physical shock. In addition, the buffer sheet 300 prevents the protective substrate 400 from colliding with the solar cell panel 200.

The buffer sheet 300 performs an anti-reflective function so that a great amount of light is incident onto the solar cell panel 200.

For example, the buffer sheet 300 may include ethylenevinylacetate resin (EVA resin).

The protective substrate 400 and the buffer sheet 300 are provided in the frame 100. In more detail, the lateral sides of the solar cell panel 200, the protective substrate 400, and the buffer sheet 300 are fixedly inserted into the frame 100.

In addition, a sealing material 101 is injected into the space between the solar cell panel 200, the protective substrate 400 and the buffer sheet 300, and the frame 100. The solar cell panel 200, the protective substrate 400, and the buffer sheet 300 are more firmly fixed into the frame 100 due to the sealing material 101.

The sealing material 101 absorbs the physical shock applied to the frame 100, thereby protecting the solar cell panel 200.

In addition, the solar cell module according to the embodiment may include wires connected to the solar cells 210, and connected to an external charging device, or another solar cell module. In addition, the solar cell module may further include bus bars to connect the wires and the solar cells 210.

The electrical shock protective part 500 is provided on the solar cell panel 200. In more detail, the electrical shock protective part 500 may be provided on the whole top surface of the solar cell panel 200. The electrical shock protective part 500 is provided below the protective substrate 400. The electrical shock protective part 500 is interposed between the protective substrate 400 and the solar cell panel 200. In more detail, the electrical shock protective part 500 is interposed between the buffer sheet 300 and the protective substrate 400. In more detail, the electrical shock protective part 500 may be coated on the bottom surface of the protective substrate 400.

The electrical shock protective part 500 is a conductor. The electrical shock protective part 500 is transparent. The electrical shock protective part 500 may include a transparent conductive material such as indium tin oxide (ITO) or indium zinc oxide (IZO).

The electrical shock protective part 500 may be formed through a vacuum deposition process. For example, a transparent conductive layer is formed by uniformly depositing the transparent conductive material on the bottom surface of the protective substrate 400. Thereafter, the electrical shock protective part 500 may be formed by patterning the transparent conductive layer through a photolithography process or by a laser.

In addition, the electrical shock protective part 500 may be formed through a printing process. For example, a paste including the transparent conductive material is printed on the bottom surface of the protective substrate 400. Thereafter, the printed paste is subject to heat treatment, so that the electrical shock protective part 500 may be formed on the bottom surface of the protective substrate 400.

In addition, after separately forming the electrical shock protective part 500, the electrical shock protective part 500 may be attached to the bottom surface of the protective substrate 400 by using an adhesive.

As shown in FIGS. 1 and 2, the electrical shock protective part 500 may have the form of a mesh. In more detail, the electrical shock protective part 500 may include a plurality of first transparent electrodes 510 and a plurality of second transparent electrodes 520.

The first transparent electrodes 510 extend in a first direction. The first transparent electrodes 510 are spaced apart from each other. In more detail, the first transparent electrodes 510 are spaced apart from each other by a predetermined interval while being arranged in parallel to each other.

The second transparent electrodes 520 cross the first transparent electrodes 510. The second transparent electrodes 520 extend in a second direction crossing the first direction. The second transparent electrodes 520 are spaced apart from each other. In more detail, the second transparent electrodes 520 are spaced apart from each other by a predetermined interval while being arranged in parallel to each other.

The first transparent electrodes 510 are connected to the second transparent electrodes 520. In more detail, the first transparent electrodes 510 and the second transparent electrodes 520 may be integrally formed with each other.

The first and second transparent electrodes 510 and 520 are provided obliquely with respect to the frame 100. In other words, the first and second transparent electrodes 510 and 520 may be inclined with respect to the extension direction of the frame 100. In addition, the first and second transparent electrodes 510 and 520 may be substantially vertically or horizontally provided with respect to the extension direction of the frame 100.

The first transparent electrodes 510 may have a width in the range of about 10*µ*m to about 1000*µ*m. The interval between the first transparent electrodes 510 is about 1.5times to about 500times greater than the width of the first transparent electrodes 510. In addition, the thickness of the first transparent electrodes 510 may be in the range of 100 to 1000.

The second transparent electrodes 520 may have a width in the range of about 10*µ*m to about 1000*µ*m. The interval between the second transparent electrodes 520 is about 1.5 times to about 500 times greater than the width of the second transparent electrodes 520. In addition, the thickness of the second transparent electrodes 520 may be in the range of 100*µ*m to 1000*µ*m.

As shown in FIG. 4, the electrical shock protective part 500 is electrically connected to the frame 100. In more detail, a connection wire 600 is connected to the electrical shock protective part 500 through a first solder 501, and the connection wire 600 is connected to the frame 100 through a second solder 102. In this case, the connection wire 600 passes through the sealing material 101.

The connection wire 600 may include a plurality of connection wires. In other words, several connection wires 600 may connect the electrical shock protective part 500 with the frame 100. In this case, the connection wires 600 may be uniformly provided at an outer portion of the electrical shock protective part 500.

The connection wire 600 may be flexible, and may include copper (Cu).

The frame 100 is grounded through an additional wire. Therefore, the electrical shock protective part 500 may be grounded through the frame 100.

According to the solar cell module of the embodiment, the solar cell panel 200 can be protected by using the electrical shock protective part 500. In particular, the electrical shock protective part 500 absorbs static electricity or a lightening stroke so that the solar cell panel 200 can be prevented from being damaged.

Therefore, the solar cell module according to the embodiment can represent improved durability and improved reliability.

In particular, as shown in FIGS. 5 and 6, a solar cell module 1 according to the embodiment may be installed in a transportation such as a vehicle or an airplane.

As shown in FIG. 5, the solar cell module 1 according to the embodiment may be installed in a roof of the vehicle. In addition, as shown in FIG. 6, the solar cell module 1 according to the embodiment may be installed in a wing of the airplane.

In addition, the electrical shock protective part 500 of the solar cell module according to the embodiment may be grounded with a body 2 of the vehicle or a body 2 of the airplane. The body 2 supports the electrical shock protective part 500. At least a portion of the body 2 may include a conductor.

When the solar cell module 1 according to the embodiment is applied to the transportation such as the vehicle or the airplane, or when the transportation is operated, static electricity may be caused due to the friction with air.

The static electricity can be easily discharged to the outside by the electrical shock protective part 500, so that the solar cell module 1 according to the embodiment can be effectively protected from the electrical shock.

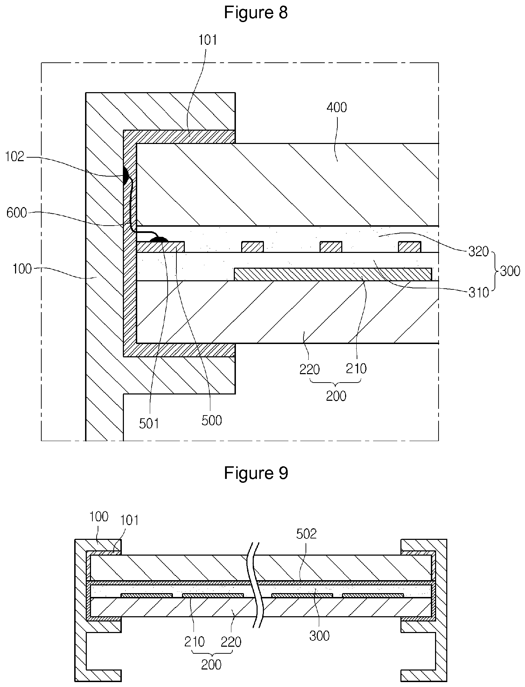

FIGS. 7 and 8 are sectional views showing a solar cell module according to another embodiment. Hereinafter, the present embodiment will be described by making reference to the above description of the solar cell module and the transportation including the same. In other words, the above description will be incorporated in the description of the present embodiment except for essential parts.

Referring to FIGS. 7 and 8, the electrical shock protective part 500 is provided in the buffer layer 400. In more detail, the buffer layer 400 includes first and second buffer layers 310 and 320. In this case, the electrical shock protective part 500 is interposed between the first and second buffer layers 310 and 320. The first and second buffer layers 310 and 320 are bonded to each other, and bonded to the electrical shock protective part 500.

The electrical shock protective part 500 is provided closer to the solar cell panel 200. Therefore, the electrical shock protective part 500 can effectively absorb the static electricity applied to the solar cell panel 200.

In addition, since the electrical shock protective part 500 is sandwiched between the two buffer layers 310 and 320, the electrical shock protective part 500 can be effectively bonded to the protective substrate 400. In other words, since the electrical shock protective part 500 is bonded to the protective substrate 400 through the second buffer layer 320, the electrical shock protective part 500 can be more effectively bonded to the protective substrate 400 when comparing with a case in which the electrical shock protective part 500 is directly bonded to the protective substrate 400.

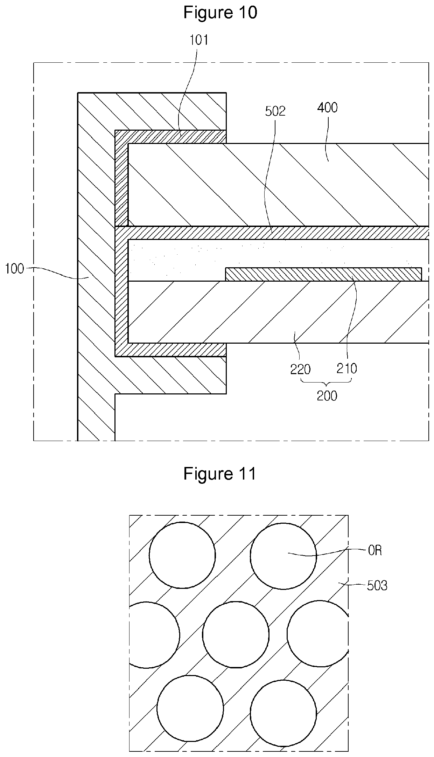

FIGS. 9 and 10 are sectional views showing a solar cell module according to still another embodiment. Hereinafter, the present embodiment will be described by making reference to the above description of the solar cell module and the transportation including the same. In other words, the above description will be incorporated in the description of the present embodiment except for essential parts.

Referring to FIGS. 9 and 10, an electrical shock protective part 502 may cover a lateral side of the buffer layer 400 and a lateral side of the solar cell panel 200. In more detail, the electrical shock protective part 502 may be coated on a lateral side of the buffer layer 400 and a lateral side of the solar cell panel 200. In addition, the electrical shock protective part 502 may be coated on the bottom surface of the solar cell panel 200.

In addition, the electrical shock protective part 502 may directly make contact with the frame 100. In other words, the electrical shock protective part 502 may be interposed between the solar cell panel 200 and the frame 100, and may directly make contact with the frame 100.

The electrical shock protective part 502 may be flexible. For example, the electrical shock protective part 502 may include conducive polymer. The conductive polymer used for the electrical shock protective part 502 may include poly-pyrrole, polysulfurnitride, or poly(3,4-ethylenedioxythiophene (PEDOT). The PEDOT may have a PEDOT:PSS structure. In addition, the conductive polymer used for the electrical shock protective part 502 may be transparent.

Since the electrical shock protective part 502 includes the conductive polymer, the electrical shock protective part 502 is flexible, and is applicable in various forms. Therefore, the electrical shock protective part 502 may be directly connected to the frame 100, and the solar cell module according to the embodiment can be easily fabricated.

FIG. 11 is a sectional views showing a solar cell module according to still another embodiment. Hereinafter, the present embodiment will be described by making reference to the above description of the solar cell module and the transportation including the same. In other words, the above description will be incorporated in the description of the present embodiment except for essential parts.

Referring to FIG. 11, an electrical shock protective part 503 includes a plurality of open regions OR. In order to form the electrical shock protective part 503, a transparent conductive material is coated on the top surface or the bottom surface of the protective substrate 400, and a coated region corresponding to the open regions OR is etched through a patterning process, thereby forming the open regions OR.

In this case, areas of the open regions OR may be variously adjusted. In other words, the open regions OR adjacent to the frame 100 have a wider area, and the central portion of the protective substrate 400 have a smaller area.

Therefore, according to the solar cell module of the present embodiment, the open region OR having a small area is formed in a region in which electrical shocks may be greatly applied. Therefore, the whole solar cell module according to the embodiment can be effectively protected from electrical shocks such as the lightening stroke or static electricity.

In addition, according to the solar cell module of the embodiment, the area of the open region can be maximized without reducing the protection performance from the electrical shocks, so that the photoelectric conversion efficiency can be increased.

The solar cell module according to the present embodiment is the solar cell apparatus in a broad sense. Therefore, the structure of the solar cell module according to the present embodiments is applicable to the solar cell apparatus having various forms.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### Industrial Applicability

The solar cell apparatus of the element is applicable to the field of the solar light generation.

## Claims

1. A solar cell apparatus (1) comprising:
a solar cell panel (200);
an electrical shock protective part (500) on the solar cell panel (200);
a frame (100) surrounding the solar cell panel and including a conductive material; and
a connection wire (600) connecting the electrical shock protective part with the frame,
**characterized in that** the electrical shock protective part (500) includes a transparent conductive material,
wherein the electrical shock protective part (500) is provided on the whole top surface of the solar cell panel (200), and
wherein the frame being grounded through an additional wire, the electrical shock protective part (500) is electrically connected to the frame (100) and grounded through it.

2. The solar cell apparatus (1) of claim 1, further comprising:
a protective substrate (400) on the solar cell panel (200); and
a buffer layer (300) between the solar cell panel (200) and the protective substrate (400),
wherein the electrical shock protective part (500) is interposed between the protective substrate (400) and the buffer layer (300) and is coated on a bottom surface of the protective substrate (400).

3. The solar cell apparatus (1) of claim 1, wherein the electrical shock protective part (500) comprises:
a plurality of first transparent electrodes (510) extending in a first direction; and
a plurality of second transparent electrodes (520) crossing the first transparent electrodes (510).

4. The solar cell apparatus of claim 3, wherein an interval between the first transparent electrodes (510) is 1.5 times to 500 times greater than a width of the first transparent electrodes (510).

5. The solar cell apparatus (1) of claim 1, further comprising:
a protective substrate (400) on the solar cell panel (200); and
a buffer layer (300) interposed between the solar cell panel (200) and the protective substrate (400),
wherein the electrical protective part (500) is provided in the buffer layer (300).

6. The solar cell apparatus (1) of claim 1, further comprising a protective substrate (400) on the solar cell panel (200), wherein the electrical protective part (500) is provided on a top surface of the protective substrate (400).

7. The solar cell apparatus (1) of claim 1, wherein the electrical shock protective part (500) comprises a conductive layer coated on a top surface and a bottom surface of a protective substrate, and the conductive layer is formed therein with a plurality of open regions to expose the top surface or the bottom surface of the protective substrate.

8. The solar cell apparatus (1) of claim 1, further comprising:
a protective substrate on the solar cell panel; and
a buffer layer interposed between the solar cell panel and the protective substrate,
wherein the electrical shock protective part covers a top surface and a bottom surface of the buffer layer.

9. A transportation device comprising:
a solar cell apparatus (1) according to claim 1; and
a body (2) to support the solar cell apparatus (1).

10. The transportation device of claim 9, wherein the electrical shock protective part (500) is grounded to the body (2).

11. The transportation device of claim 10, wherein the solar cell apparatus (1) further comprises a protective substrate (400) on the solar cell panel (200), wherein the electrical shock protective part (500) is provided on a top surface or a bottom surface of the protective substrate (400).

## Patentansprüche

1. Solarzelleneinrichtung (1), umfassend:
ein Solarzellenpaneel (200);
einen Schutzteil gegen Elektroschock (500) auf dem Solarzellenpaneel (200);
einen Rahmen (100), welcher das Solarpaneel umgibt und ein leitendes Material beinhaltet; und
einen Verbindungsdraht (600), welcher den Schutzteil gegen Elektroschock mit dem Rahmen verbindet,
**dadurch gekennzeichnet, dass** der Schutzteil gegen Elektroschock (500) ein transparentes leitendes Material beinhaltet,
wobei der Schutzteil gegen Elektroschock (500) auf der gesamten oberen Oberfläche des Solarzellenpaneels (200) bereitgestellt ist, und
wobei der Rahmen, durch einen zusätzlichen Draht geerdet ist, der Schutzteil gegen Elektroschock (500) mit dem Rahmen (100) elektrisch verbunden und durch ihn geerdet ist.

2. Solarzelleneinrichtung (1) nach Anspruch 1, weiter umfassend:
ein schützendes Substrat (400) auf dem Solarzellenpaneel (200); und
eine Pufferschicht (300) zwischen dem Solarzellenpaneel (200) und dem schützenden Substrat (400),
wobei der Schutzteil gegen Elektroschock (500) zwischen dem schützenden Substrat (400) und der Pufferschicht (300) eingeschoben ist und auf einer unteren Oberfläche des schützenden Substrats (400) beschichtet ist.

3. Solarzelleneinrichtung (1) nach Anspruch 1, wobei der Schutzteil gegen Elektroschock (500) umfasst:
eine Vielzahl von ersten transparenten Elektroden (510), welche sich in einer ersten Richtung erstrecken; und
eine Vielzahl von zweiten transparenten Elektroden (520), welche die ersten transparenten Elektroden (510) kreuzen.

4. Solarzelleneinrichtung nach Anspruch 3, wobei ein Intervall zwischen den ersten transparenten Elektroden (510) 1,5 Mal bis 500 Mal größer ist als eine Breite der ersten transparenten Elektroden (510).

5. Solarzelleneinrichtung (1) nach Anspruch 1, weiter umfassend:
ein schützendes Substrat (400) auf dem Solarzellenpaneel (200); und
eine Pufferschicht (300), welche zwischen dem Solarzellenpaneel (200) und dem schützenden Substrat (400) eingeschoben ist,
wobei der elektrische Schutzteil (500) in der Pufferschicht (300) bereitgestellt ist.

6. Solarzelleneinrichtung (1) nach Anspruch 1, weiter ein schützendes Substrat (400) auf dem Solarzellenpaneel (200) umfassend, wobei der elektrische Schutzteil (500) auf einer oberen Oberfläche des schützenden Substrats (400) bereitgestellt ist.

7. Solarzelleneinrichtung (1) nach Anspruch 1, wobei der Schutzteil gegen Elektroschock (500) eine leitende Schicht umfasst, mit welcher eine obere Oberfläche und eine untere Oberfläche eines schützenden Substrats beschichtet ist, und die leitende Schicht darin mit einer Vielzahl von offenen Regionen gebildet ist, um die obere Oberfläche oder die untere Oberfläche des schützenden Substrats freizulegen.

8. Solarzelleneinrichtung (1) nach Anspruch 1, weiter umfassend:
ein schützendes Substrat auf dem Solarzellenpaneel; und
eine Pufferschicht, welche zwischen dem Solarzellenpaneel und dem schützenden Substrat eingeschoben ist,
wobei der Schutzteil gegen Elektroschock eine obere Oberfläche und eine untere Oberfläche der Pufferschicht bedeckt.

9. Transportvorrichtung, umfassend:
eine Solarzelleneinrichtung (1) nach Anspruch 1; und
einen Korpus (2), um die Solarzelleneinrichtung (1) zu tragen.

10. Transportvorrichtung nach Anspruch 9, wobei der Schutzteil gegen Elektroschock (500) gegen den Korpus (2) geerdet ist.

11. Transportvorrichtung nach Anspruch 10, wobei die Solarzelleneinrichtung (1) weiter ein schützendes Substrat (400) auf dem Solarzellenpaneel (200) umfasst, wobei der Schutzteil gegen Elektroschock (500) auf einer oberen Oberfläche oder einer unteren Oberfläche des schützenden Substrats (400) ist.

## Revendications

1. Appareil à cellules solaires (1) comprenant :
un panneau à cellules solaires (200) ;
une partie de protection contre les chocs électriques (500) sur le panneau à cellules solaires (200) ;
un cadre (100) entourant le panneau à cellules solaires et incluant un matériau conducteur ; et
un fil de connexion (600) connectant la partie de protection contre les chocs électriques au cadre,
**caractérisé en ce que** la partie de protection contre les chocs électriques (500) inclut un matériau conducteur transparent,
dans lequel la partie de protection contre les chocs électriques (500) est disposée sur la surface supérieure entière du panneau à cellules solaires (200), et
dans lequel le cadre étant mis à la terre par le biais d'un fil supplémentaire, la partie de protection contre les chocs électriques (500) est électriquement connectée au cadre (100) et mise à la terre par le biais de celui-ci.

2. Appareil à cellules solaires (1) selon la revendication 1, comprenant en outre :
un substrat de protection (400) sur le panneau à cellules solaires (200) ; et
une couche tampon (300) entre le panneau à cellules solaires (200) et le substrat de protection (400),
dans lequel la partie de protection contre les chocs électriques (500) est interposée entre le substrat de protection (400) et la couche tampon (300) et est étalée sur une surface inférieure du substrat de protection (400).

3. Appareil à cellules solaires (1) selon la revendication 1, dans lequel la partie de protection contre les chocs électriques (500) comprend :
une pluralité de premières électrodes transparentes (510) s'étendant dans une première direction ; et
une pluralité de secondes électrodes transparentes (520) coupant les premières électrodes transparentes (510).

4. Appareil à cellules solaires (1) selon la revendication 3, dans lequel un intervalle entre les premières électrodes transparentes (510) est 1,5 fois à 500 fois plus grand qu'une largeur des premières électrodes transparentes (510).

5. Appareil à cellules solaires (1) selon la revendication 1, comprenant en outre :
un substrat de protection (400) sur le panneau à cellules solaires (200) ; et
une couche tampon (300) interposée entre le panneau à cellules solaires (200) et le substrat de protection (400),
dans lequel la partie de protection électrique (500) est disposée dans la couche tampon (300).

6. Appareil à cellules solaires (1) selon la revendication 1, comprenant en outre un substrat de protection (400) sur le panneau à cellules solaires (200), dans lequel la partie de protection électrique (500) est disposée sur une surface supérieure du substrat de protection (400).

7. Appareil à cellules solaires (1) selon la revendication 1, dans lequel la partie de protection contre les chocs électriques (500) comprend une couche conductrice étalée sur une surface supérieure et une surface inférieure d'un substrat de protection, et la couche conductrice est formée dans celle-ci avec une pluralité de régions ouvertes pour exposer la surface supérieure ou la surface inférieure du substrat de protection.

8. Appareil à cellules solaires (1) selon la revendication 1, comprenant en outre :
un substrat de protection sur le panneau à cellules solaires ; et
une couche tampon interposée entre le panneau à cellules solaires et le substrat de protection,
dans lequel la partie de protection contre les chocs électriques recouvre une surface supérieure et une surface inférieure de la couche tampon.

9. Dispositif de transport comprenant :
un appareil à cellules solaires (1) selon la revendication 1 ; et
un corps (2) pour supporter l'appareil à cellules solaires (1).

10. Dispositif de transport selon la revendication 9, dans lequel la partie de protection contre les chocs électriques (500) est mise à la terre au corps (2).

11. Dispositif de transport selon la revendication 10, dans lequel l'appareil à cellules solaires (1) comprend en outre un substrat de protection (400) sur le panneau à cellules solaires (200), dans lequel la partie de protection contre les chocs électriques (500) est disposée sur une surface supérieure ou une surface inférieure du substrat de protection (400).
